# EUROPEAN PATENT APPLICATION

(11) **EP 4 557 386 A1**
(43) Date of publication of application: **21.05.2025**
(21) Application number: 23856218.5
(22) Date of filing: 16.06.2023
(51) Int. Cl.: H01L 31/18, H01L 31/0216, H01L 31/0224, H01L 31/0236

(54) **SOLAR CELL AND MANUFACTURING METHOD THEREFOR**

(30) Priority: 22.08.2022 CN 202211007498
(71) Applicant: Longi Solar Technology (Taizhou) Co., Ltd., Taizhou, Jiangsu 225300 (CN)
(72) Inventor: LI, Wenqiang, Taizhou, Jiangsu 225300 (CN); TONG, Hongbo, Taizhou, Jiangsu 225300 (CN); YU, Long, Taizhou, Jiangsu 225300 (CN); DING, Chao, Taizhou, Jiangsu 225300 (CN); LI, Hua, Taizhou, Jiangsu 225300 (CN)
(74) Representative: Pfenning, Meinig & Partner mbB
(86) International application number: PCT/CN2023/100863
(87) International publication number: WO 2024/041126

(57) **Abstract**

The present invention discloses a solar cell and a manufacturing method therefor, and relates to the field of solar cell technologies, to reduce an etching amount of a first region by a wet chemical processing solution under a delayed etching effect of a tunneling passivation layer so that a surface structure of the first region after wet chemical processing meets requirements of a preset scheme, thereby improving photoelectric conversion efficiency of the solar cell. The method for manufacturing a solar cell includes: providing a semiconductor substrate, where the semiconductor substrate has a first region and a second region; forming a tunneling passivation layer on at least the first region; and etching the first region in wet chemical processing under a delayed etching effect of the tunneling passivation layer, where a surface structure of the first region is different from a surface structure of the second region after the wet chemical processing.

## Description

### CROSS-REFERENCE TO RELATED APPLICATIONS

This application claims priority to Chinese Patent Application No. 202211007498.5, filed with the China National Intellectual Property Administration on August 22, 2022 and entitled "METHOD FOR MANUFACTURING SOLAR CELL", which is incorporated herein by reference in its entirety.

### TECHNICAL FIELD

The present invention relates to the field of solar cell technologies, and in particular, to a solar cell and a manufacturing method therefor.

### BACKGROUND

As a green energy source, solar cells play a positive role in energy saving and emission reduction, and are increasingly widely used. A solar cell is an apparatus that converts sunlight energy into electric energy. Specifically, the solar cell generates carriers by using the photovoltaic principle, and then leads out the carriers by electrodes, so that electrical energy can be efficiently used.

However, in existing methods for manufacturing a solar cell, after at least one surface region of a semiconductor substrate is etched in wet chemical processing, one surface region is excessively processed, resulting in reduction in photoelectric conversion efficiency of the solar cell.

### SUMMARY

An objective of the present invention is to provide a solar cell and a manufacturing method therefor, to reduce an etching amount of a first region by a wet chemical processing solution under a delayed etching effect of a tunneling passivation layer, so that a surface structure of the first region after wet chemical processing meets requirements of a preset scheme, thereby improving photoelectric conversion efficiency of the solar cell.

The present invention provides a method for manufacturing a solar cell. The method for manufacturing a solar cell includes:
providing a semiconductor substrate, where the semiconductor substrate has a first region and a second region;
forming a tunneling passivation layer on at least the first region; and
etching the first region in wet chemical processing under a delayed etching effect of the tunneling passivation layer, where a surface structure of the first region is different from a surface structure of the second region after the wet chemical processing.

When the foregoing technical scheme is used, the semiconductor substrate included in a solar cell provided in the present invention has the first region and the second region. **In** addition, before the first region is etched in the wet chemical processing, the tunneling passivation layer is formed on at least the first region. Based on this, in a process of etching the first region in the wet chemical processing, the tunneling passivation layer on at least the first region may have the delayed etching effect, to reduce an etching amount of a surface of the first region by a wet chemical processing solution. It can be seen that, compared with an existing manufacturing method in which the solution for performing the wet chemical processing is directly used to process the surface of the first region, in the manufacturing method provided in the present invention, the surface of the first region after the wet chemical processing is not excessively processed, so that the surface structure of the first region after the wet chemical processing meets requirements of a preset scheme, thereby improving a yield of the solar cell. In addition, the semiconductor substrate after the wet chemical processing is also not excessively thinned, to reduce a risk of cracking after the semiconductor substrate is thinned; and a transmission path of light in the semiconductor substrate can also be increased, to increase a probability that light incident into the semiconductor substrate is absorbed, thereby improving photoelectric conversion efficiency of the solar cell.

In a possible implementation, a thickness of the tunneling passivation layer ranges from 1.4 nm to 1.8 nm; and/or It should be understood that, within a specific range, the thickness of the tunneling passivation layer is proportional to delayed time of the tunneling passivation layer etched. In this case, when the thickness of the tunneling passivation layer ranges from 1.4 nm to 1.8 nm, the thickness of the tunneling passivation layer is moderate. In this way, the delayed time is short because the tunneling passivation layer is easily etched through by performing the wet chemical processing due to a small thickness of the tunneling passivation layer, thereby further ensuring that the surface of the first region after the wet chemical processing is not excessively processed. In addition, a material waste due to a large thickness of the tunneling passivation layer can also be avoided, thereby reducing manufacturing costs of the solar cell. In addition, the tunneling passivation layer has the delayed etching effect. When the tunneling passivation layer is applied to a tunneling passivation contact structure, the thickness of the tunneling passivation layer is set to the foregoing range, which can also avoid difficulty of carriers passing through the tunneling passivation layer due to the large thickness of the tunneling passivation layer, to reduce resistance of the tunneling passivation layer, thereby further improving the photoelectric conversion efficiency of the solar cell.

In a possible implementation, a material of the tunneling passivation layer is silicon oxide, aluminum oxide, titanium oxide, hafnium oxide, gallium oxide, titanium pentoxide, niobium pentoxide, silicon nitride, silicon carbonitride, aluminum nitride, titanium nitride, or titanium carbonitride. In this case, an optional range of the material of the tunneling passivation layer is large, so that applicability of the method for manufacturing a solar cell provided in the present invention in different application scenarios can be improved.

In a possible implementation, the first region and the second region are simultaneously etched in the wet chemical processing, to cause the surface structure of the first region to form a convex structure, a pyramid structure, or an inverted pyramid structure, and cause the surface structure of the second region to form a convex structure, a pyramid structure, or an inverted pyramid structure.

When the foregoing technical scheme is used, the first region and the second region are simultaneously etched in the wet chemical processing, so that efficiency of manufacturing the solar cell can be improved, and productivity of the solar cell can be improved. In addition, after the first region and the second region are simultaneously etched in the wet chemical processing, the surface structure of the first region and the surface structure of the second region have a plurality of possible implementations, so that applicability of the method for manufacturing a solar cell provided in the present invention in different application scenarios can be improved.

In a possible implementation, the forming a tunneling passivation layer on at least the first region includes: forming the tunneling passivation layer on at least the first region and the second region;
after the forming the tunneling passivation layer on at least the first region and the second region, and before the etching the first region in wet chemical processing, the method for manufacturing a solar cell further includes: forming a first doped semiconductor layer on at least the tunneling passivation layer corresponding to the second region;
the surface structure of the second region is a convex structure; and the surface structure of the first region after the wet chemical processing is a convex structure, a pyramid structure, or an inverted pyramid structure.

When the foregoing technical scheme is used, the first doped semiconductor layer and the tunneling passivation layer located on the second region may form a tunneling passivation contact structure. In this case, the solar cell manufactured by using the manufacturing method provided in the present invention is a tunneling oxide passivation contact solar cell. The tunneling passivation layer in the tunneling passivation contact structure allows majority carriers to tunnel into the first doped semiconductor layer and also inhibits minority carriers passing through the first doped semiconductor layer, so that the majority carriers are transported through the first doped semiconductor layer and collected by corresponding electrodes, a recombination rate of carriers of different conductivity types on a surface of the second region is reduced, and interface passivation and selective carrier collection are implemented, thereby further improving the photoelectric conversion efficiency of the solar cell. In addition, the surface structure of the second region and the surface structure of the first region after the wet chemical processing have a plurality of possible implementations, and an appropriate implementation may be selected according to requirements of different application scenarios, so that applicability of the method for manufacturing a solar cell provided in the present invention in different application scenarios can be improved.

In a possible implementation, the semiconductor substrate has a first surface and a second surface opposite to each other; in a direction parallel to the second surface, the second surface has first regions and a second region that are alternately arranged;
the forming a tunneling passivation layer on at least the first region includes: forming the tunneling passivation layer on at least the first regions and the second region;
the surface structure of one of the first regions after the wet chemical processing is a convex structure, a pyramid structure, or an inverted pyramid structure; and the surface structure of the second region after the wet chemical processing is a convex structure.

When the foregoing technical scheme is used, the surface structure of the second region is the convex structure. Because the convex structure is a pyramid base structure that remains after the pyramid structure is polished, a top surface of the pyramid base structure is flat, and a surface of the second region is a flat polished surface. In this way, film forming quality of the tunneling passivation layer and the first doped semiconductor layer on the second region can be improved, so that a tunneling passivation contact structure formed by the tunneling passivation layer and the first doped semiconductor layer located on the second region can have excellent interface passivation and selective carrier collection characteristics.

In an example, after the forming the tunneling passivation layer on at least the first regions and the second region, and before the etching the first region in wet chemical processing, the method for manufacturing a solar cell further includes: forming a first doped semiconductor layer on at least the tunneling passivation layer corresponding to the second region. For beneficial effects in this case, reference may be made to the foregoing analysis of beneficial effects of the tunneling passivation contact structure formed by the first doped semiconductor layer and the tunneling passivation layer located on the second region. Details are not described herein again.

For example, the surface structure of the first region after the wet chemical processing is the pyramid structure or the inverted pyramid structure.

When the foregoing technical scheme is used, the pyramid structure and the inverted pyramid structure are a textured structure, and the textured structure has a light trapping effect. Therefore, when the second surface having the first region corresponds to a front surface of the solar cell, more light can be refracted into the semiconductor substrate through the surface of the first region, thereby further improving the photoelectric conversion efficiency of the solar cell.

In an example, the first surface and the first region are simultaneously etched in the wet chemical processing, to cause a surface structure of the first surface to be different from the surface structure of the first region. In this case, when the foregoing technical scheme is used, the first surface and the first region are simultaneously etched in the wet chemical processing, so that efficiency of manufacturing the solar cell can be improved, and productivity of the solar cell can be improved.

For example, the solar cell is a double-sided contact solar cell. In this case, the first surface and the first region are simultaneously etched in the wet chemical processing, to cause the surface structure of the first surface to form a convex structure, and cause the surface structure of the first region to form the convex structure, the pyramid structure, or the inverted pyramid structure.

When the foregoing technical scheme is used, when the surface structure of the first surface after the wet chemical processing is the convex structure, a surface of the first surface is a flat polished surface. The polished surface has a good reflection characteristic. Therefore, when the first surface corresponds to a back surface of the double-sided contact solar cell, light reaching the first surface can be at least partially reflected back into the semiconductor substrate and can be reused by the semiconductor substrate, thereby further improving the photoelectric conversion efficiency of the double-sided contact solar cell. In this case, the second surface corresponds to the front surface of the double-sided contact solar cell. After the wet chemical processing, the surface structure of the first region located on the second surface may form any one of the convex structure, the pyramid structure, or the inverted pyramid structure, so that applicability of the manufacturing method provided in the present invention in different application scenarios is improved.

For example, a pyramid base width of the surface structure formed on the first surface is greater than a pyramid base width of the surface structure formed on the first region.

When the foregoing technical scheme is used, a pyramid base width corresponding to a convex structure is greater than a pyramid base width corresponding to a pyramid structure or an inverted pyramid structure. Therefore, when the surface structure on the first surface is the convex structure and the pyramid base width of the surface structure formed on the first surface is greater than the pyramid base width of the surface structure formed on the first region, the surface structure of the first region after the wet chemical processing may be the pyramid structure or the inverted pyramid structure. In this case, the second surface corresponds to the front surface of the double-sided contact solar cell, so that more light can be refracted into the semiconductor substrate through the surface of the first region, thereby further improving the photoelectric conversion efficiency of the double-sided contact solar cell.

In another example, the solar cell is a back contact solar cell. In this case, the first surface and the first region are simultaneously etched in the wet chemical processing, to cause the surface structure of the first surface to form a pyramid structure, and cause the surface structure of the first region to form the convex structure, the pyramid structure, or the inverted pyramid structure.

When the foregoing technical scheme is used, when the solar cell is the back contact solar cell, because two types of electrodes with opposite polarities are both located on a back surface of the solar cell and the front surface of the back contact solar cell is not affected by shading of a metal electrode, the back contact solar cell has a higher short-circuit current than a double-sided contact solar cell. In addition, the first surface corresponds to the front surface of the back contact solar cell. Therefore, more light can be refracted into the semiconductor substrate through the first surface, thereby further improving the photoelectric conversion efficiency of the back contact solar cell. In addition, the second surface corresponds to the back surface of the back contact solar cell. After the wet chemical processing, the surface structure of the first region located on the second surface may form any one of the convex structure, the pyramid structure, or the inverted pyramid structure, so that applicability of the manufacturing method provided in the present invention in different application scenarios is improved.

For example, a pyramid base width of the surface structure arranged on the first surface is less than a pyramid base width of the surface structure formed on the first region.

When the foregoing technical scheme is used, as described above, the pyramid base widths corresponding to the pyramid structure and the inverted pyramid structure are both less than the pyramid base width corresponding to the convex structure. Therefore, when the surface structure on the first surface is the pyramid structure and the pyramid base width of the surface structure formed on the first surface is less than the pyramid base width of the surface structure formed on the first region, the surface structure of the first region after the wet chemical processing may be the convex structure. In this case, the second surface corresponds to the back surface of the back contact solar cell, so that at least part of light can be reflected back into the semiconductor substrate through the first region, thereby further improving the photoelectric conversion efficiency of the back contact solar cell.

In a possible implementation, when the solar cell is a back contact solar cell, a pyramid base width of the surface structure formed on the second region is different from a pyramid base width of the surface structure formed on the first region after the wet chemical processing.

When the foregoing technical scheme is used, specific positions of a first doped semiconductor layer and a second doped semiconductor layer (or a doped region) may be distinguished based on a difference between the pyramid base width of the surface structure arranged on the second region and the pyramid base width of the surface structure formed on the first region after the wet chemical processing, so that the first doped semiconductor layer and the second doped semiconductor layer (or the doped region) are more distinguishable. In this way, difficulty of accurately arranging electrodes with a same polarity on the first doped semiconductor layer and the second doped semiconductor layer (or the doped region) respectively can be reduced, so that a risk of a short circuit in the back contact solar cell is reduced because the first doped semiconductor layer and the second doped semiconductor layer (or the doped region) of opposite conductivity types are coupled through the electrodes, thereby improving electrical stability of the back contact solar cell.

In a possible implementation, after the providing a semiconductor substrate, and before the etching the first region in wet chemical processing, the method for manufacturing a solar cell includes:
sequentially forming the tunneling passivation layer and the first doped semiconductor layer that are entirely arranged on the second surface; and
patterning the first doped semiconductor layer, so that only the first doped semiconductor layer located on the second region is retained.

When the foregoing technical scheme is used, the first doped semiconductor layer entirely arranged on the second surface is patterned, to form, on (or in) the first region, a second doped semiconductor layer (or a doped region) having a conductivity type opposite to a conductivity type of the first doped semiconductor layer. In addition, in an actual application process, the first surface may be texturized and the first doped semiconductor layer may be patterned simultaneously through the wet chemical processing, to improve efficiency of manufacturing the back contact solar cell. In addition, in this case, the tunneling passivation layer and the first doped semiconductor layer located on the first region have the delayed etching effect, and may prolong etch delay time for a solution for texturizing and patterning to etch to the surface of the first region within a specific range, so that long processing time can be sought for the pyramid structure that meets the requirements of the preset scheme and that is formed on the first surface. In this way, quality of the pyramid structure formed on the first surface is improved, thereby further improving the photoelectric conversion efficiency of the back contact solar cell.

In a possible implementation, a surface of the first region is recessed into the semiconductor substrate relative to a surface of the second region after the wet chemical processing.

When the foregoing technical scheme is used, the first doped semiconductor layer and the second doped semiconductor layer (or the doped region) that have opposite doping types in the back contact solar cell are respectively formed on the second region and on (or in) the first region. Therefore, when the surface of the first region is recessed into the semiconductor substrate relative to the surface of the second region after the wet chemical processing, the first doped semiconductor layer may be staggered with at least a part of the second doped semiconductor layer (or the first doped semiconductor layer may be entirely staggered with the doped region) in a thickness direction of the semiconductor substrate, so that no electric leakage occurs between the first doped semiconductor layer and the second doped semiconductor layer (or the doped region).

In a possible implementation, the second surface has a middle region and edge isolation regions extending outward from the middle region; and the first regions and the second region are located in the middle region. In this case, a surface of one of the edge isolation regions is recessed into the semiconductor substrate relative to the surface of the second region after the wet chemical processing.

When the foregoing technical scheme is used, in a process of actually manufacturing the first doped semiconductor layer and the second doped semiconductor layer (or the doped region) that have opposite doping types included in the back contact solar cell, a doped element of one of the first doped semiconductor layer and the second doped semiconductor layer (or the doped region) is also doped into a side surface of the semiconductor substrate. Based on this, the surface of the edge isolation region is recessed into the semiconductor substrate relative to the surface of the second region after the wet chemical processing, so that the other of the first doped semiconductor layer and the second doped semiconductor layer (or the doped region) can be separated from the side surface of the semiconductor substrate by the edge isolation region. In this way, no electric leakage occurs between the side surface of the semiconductor substrate and the other of the first doped semiconductor layer and the second doped semiconductor layer (or the doped region), thereby improving the photoelectric conversion efficiency of the back contact solar cell.

In a possible implementation, after the etching the first region in wet chemical processing, the method for manufacturing a solar cell further includes: forming a doped region in the first region, where a conductivity type of the doped region is opposite to a conductivity type of the first doped semiconductor layer; or forming a second doped semiconductor layer on the first region, where a conductivity type of the second doped semiconductor layer is opposite to a conductivity type of the first doped semiconductor layer.

In a possible implementation, after the forming a doped region in the first region, the method for manufacturing a solar cell further includes: forming a surface passivation layer on at least the first doped semiconductor layer and the doped region.

When the foregoing technical scheme is used, the surface passivation layer may passivate a side of the first doped semiconductor layer and the doped region facing away from the semiconductor substrate, to reduce a carrier recombination rate on the side of the first doped semiconductor layer and the doped region facing away from the semiconductor substrate, thereby further improving the photoelectric conversion efficiency of the back contact solar cell.

In another possible implementation, after the forming a second doped semiconductor layer on the first region, the method for manufacturing a solar cell further includes: forming a surface passivation layer on at least the first doped semiconductor layer and the second doped semiconductor layer. For beneficial effects in this case, reference may be made to the foregoing beneficial effects of the formed surface passivation layer on at least the first doped semiconductor layer and the doped region. Details are not described herein again.

In a possible implementation, after the etching the first region in wet chemical processing, and before the forming a doped region in the first region, the method for manufacturing a solar cell further includes: forming a surface passivation layer on at least the first region and the first doped semiconductor layer; and forming a first electrode penetrating the surface passivation layer, where a bottom of the first electrode is in contact with the first region; and
the forming a doped region in the first region includes: forming the doped region in the first region by using the first electrode as a doping source.

When the foregoing technical scheme is used, the surface passivation layer may passivate the surface of the first region and a side of the first doped semiconductor layer facing away from the semiconductor substrate, to reduce a carrier recombination rate on the surface of the first region and the side of the first doped semiconductor layer facing away from the semiconductor substrate. In addition, the first electrode penetrating the surface passivation layer is used as the doping source, so that the doped region can be formed only within a range in which the first region is in contact with the first electrode, so that no electric leakage occurs when the doped region comes into contact with the first doped semiconductor layer. In addition, a process of forming a mask layer by forming the doped region only in the first region can be saved, thereby simplifying a process of manufacturing the back contact solar cell.

The present invention further provides a solar cell. The solar cell is prepared according to any method for manufacturing a solar cell described above.

The foregoing descriptions are merely an overview of the technical schemes in this application. In order that technical means of this application can be understood more clearly so that the technical schemes can be implemented according to content of the descriptions, and in order that the foregoing and other objectives, features, and advantages of this application can be understood more clearly, specific implementations of this application are described below.

### BRIEF DESCRIPTION OF THE DRAWINGS

To describe technical schemes in embodiments of this application or the related art more clearly, the following briefly introduces accompanying drawings required for describing the embodiments or the related art. Apparently, the accompanying drawings in the following descriptions show some of the embodiments of this application, and a person of ordinary skill in the art still derives other drawings from these accompanying drawings without creative efforts.
FIG. 1 is a flowchart of a method for manufacturing a solar cell according to an embodiment of the present invention;
FIG. 2 is a schematic longitudinal cross-sectional view of a first structure of a semiconductor substrate according to an embodiment of the present invention;
FIG. 3 is a schematic longitudinal cross-sectional view of a second structure of a semiconductor substrate according to an embodiment of the present invention;
Parts (1) to (4) in FIG. 4 are schematic diagrams of four types of distribution of a first region and a second region on a semiconductor substrate when the first region and the second region are located on different surfaces according to an embodiment of the present invention;
FIG. 5 is a schematic diagram of distribution of a first region and a second region on a second surface of a semiconductor substrate when the second surface has only the first region and the second region according to an embodiment of the present invention;
FIG. 6 is a schematic diagram of distribution of regions on a second surface of a semiconductor substrate when the second surface has edge isolation regions and a middle region according to an embodiment of the present invention;
FIG. 7 is a schematic longitudinal cross-sectional view of a first structure obtained after a tunneling passivation layer is formed when a first region and a second region are located on different surfaces according to an embodiment of the present invention;
FIG. 8 is a schematic longitudinal cross-sectional view of a structure obtained after a second region is etched in wet chemical processing when a first region and the second region are located on different surfaces according to an embodiment of the present invention;
FIG. 9 is a schematic longitudinal cross-sectional view of a structure obtained after a first region and a second region are simultaneously etched in wet chemical processing when the first region and the second region are located on a same surface according to an embodiment of the present invention;
FIG. 10 is a schematic longitudinal cross-sectional view of a structure obtained after a tunneling passivation layer on a first region and a second region and a first doped semiconductor layer located on the second region are formed when both the first region and the second region are located on a second surface according to an embodiment of the present invention;
FIG. 11 is a schematic longitudinal cross-sectional view of a first structure obtained after a first surface and a first region are simultaneously etched in wet chemical processing according to an embodiment of the present invention;
FIG. 12 is a schematic longitudinal cross-sectional view of a structure obtained after a tunneling passivation layer and a first doped semiconductor layer are sequentially formed on a first region and a second region according to an embodiment of the present invention;
FIG. 13 is a schematic longitudinal cross-sectional view of a structure obtained after a material layer for manufacturing a mask layer is formed on a first doped semiconductor layer according to an embodiment of the present invention;
FIG. 14 is a schematic longitudinal cross-sectional view of a structure obtained after a mask layer is formed on a first doped semiconductor layer according to an embodiment of the present invention;
FIG. 15 is a schematic longitudinal cross-sectional view of a structure obtained after a first doped semiconductor layer is patterned under a masking effect of a mask layer according to an embodiment of the present invention;
FIG. 16 is a schematic longitudinal cross-sectional view of a second structure obtained after a first surface and a first region are simultaneously etched in wet chemical processing according to an embodiment of the present invention;
FIG. 17 is a schematic longitudinal cross-sectional view of a third structure obtained after a first surface and a first region are simultaneously etched in wet chemical processing according to an embodiment of the present invention;
FIG. 18 is a schematic longitudinal cross-sectional view of a fourth structure obtained after a first surface and a first region are simultaneously etched in wet chemical processing according to an embodiment of the present invention;
FIG. 19 is a schematic longitudinal cross-sectional view of a structure obtained after surfaces of edge isolation regions and a surface of a first region are recessed into a semiconductor substrate relative to a surface of a second region after wet chemical processing according to an embodiment of the present invention;
FIG. 20 is a schematic longitudinal cross-sectional view of a first structure obtained after a doped region is formed according to an embodiment of the present invention;
FIG. 21 is a schematic longitudinal cross-sectional view of a first structure obtained after a second doped semiconductor layer is formed according to an embodiment of the present invention;
FIG. 22 is a schematic longitudinal cross-sectional view of a second structure obtained after a second doped semiconductor layer is formed according to an embodiment of the present invention;
FIG. 23 is a schematic longitudinal cross-sectional view of a structure obtained after a surface passivation layer is formed according to an embodiment of the present invention;
FIG. 24 is a schematic longitudinal cross-sectional view of a structure obtained after a first electrode is formed according to an embodiment of the present invention;
FIG. 25 is a schematic longitudinal cross-sectional view of a second structure obtained after a doped region is formed according to an embodiment of the present invention; and
FIG. 26 is a schematic longitudinal cross-sectional view of a structure obtained after a first electrode and a second electrode are formed according to an embodiment of the present invention.

Reference numerals: 1-semiconductor substrate, 2-first region, 3-second region, 4-tunneling passivation layer, 5-first surface, 6-second surface, 7-first doped semiconductor layer, 8-mask layer, 9-middle region, 10-edge isolation region, 11-doped region, 12-second doped semiconductor layer, 13-surface passivation layer, 14-first electrode, 15-second electrode, and 16-third region.

### DETAILED DESCRIPTION

To make the objectives, technical schemes, and advantages of the embodiments of this application clearer, the following clearly and completely describes the technical schemes in the embodiments of this application with reference to the accompanying drawings in the embodiments of this application. Apparently, the described embodiments are some rather than all of the embodiments of this application. All other embodiments obtained by a person of ordinary skill in the art based on the embodiments of this application without creative efforts shall fall within the protection scope of this application.

The embodiments of the present disclosure are described below in detail with reference to the accompanying drawings. However, it should be understood that, these descriptions are merely exemplary, and are not intended to limit the scope of the present disclosure. In addition, in the following descriptions, descriptions of well-known structures and technologies are omitted, to avoid unnecessarily confusing the concepts of the present disclosure.

Schematic diagrams of various structures according to the embodiments of the present disclosure are shown in the accompanying drawings. The accompanying drawings are not drawn to scale, some details are enlarged for the objective of clarity, and some details may be omitted. Shapes of various regions and layers shown in the accompanying drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when one layer/element is referred to as being located "on" another layer/element, the layer/element may be directly located on the another layer/element, or an intermediate layer/element may exist between the layer/element and the another layer/element. In addition, if one layer/element is located "above" another layer/element in an orientation, when the orientation is turned, the layer/element may be located "below" the another layer/element. To make the technical problems to be resolved in the present invention, the technical schemes, and beneficial effects more comprehensible, the following further describes the present invention in detail with reference to the accompanying drawings and embodiments. It should be understood that, the specific embodiments described herein are merely used to explain the present invention but are not intended to limit the present invention.

In addition, the terms "first" and "second" are used for descriptive objectives only and are not to be construed as indicating or implying relative importance or implicitly indicating the number of technical features indicated. Therefore, a feature defined by "first" or "second" may explicitly or implicitly include one or more features. In the descriptions of the present invention, unless otherwise explicitly specified, "plurality of" means two or more than two; and unless otherwise explicitly and specifically limited, "several" means one or more than one.

In the descriptions of the present invention, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two elements, or an interaction relationship between two elements. The specific meanings of the above terms in the present invention may be understood according to specific circumstances for a person of ordinary skill in the art.

As a green energy source, solar cells play a positive role in energy saving and emission reduction, and are increasingly widely used. A solar cell is an apparatus that converts sunlight energy into electric energy. Specifically, the solar cell generates carriers by using the photovoltaic principle, and then leads out the carriers by electrodes, so that electrical energy can be efficiently used.

However, in existing methods for manufacturing a solar cell, after at least one surface region of a semiconductor substrate is etched in wet chemical processing, one surface region is excessively processed, resulting in reduction in photoelectric conversion efficiency of the solar cell.

For example, in the existing manufacturing methods, a front surface of the solar cell is etched in wet chemical processing, to cause the surface to be textured, and a wet chemical processing solution also causes a back surface of the solar cell to be texturized. In this way, the semiconductor substrate is significantly thinned, and a transmission path of light in the semiconductor substrate is shortened. As a result, a probability that light incident into the semiconductor substrate is absorbed is reduced, and finally photoelectric conversion efficiency of the solar cell is reduced.

For another example, in the existing manufacturing methods of manufacturing a back contact solar cell, after a first doped semiconductor layer is formed on a back surface of the semiconductor substrate, the first doped semiconductor layer on a part region of the semiconductor substrate needs to be removed, to subsequently form a second doped semiconductor layer having a conductivity type opposite to a conductivity type of the first doped semiconductor layer in (or on) the part region of the semiconductor substrate. However, when the first doped semiconductor layer is selectively etched through the wet chemical processing, the part region of the semiconductor substrate removed is excessively processed, and the semiconductor substrate is significantly thinned, resulting in the foregoing problems.

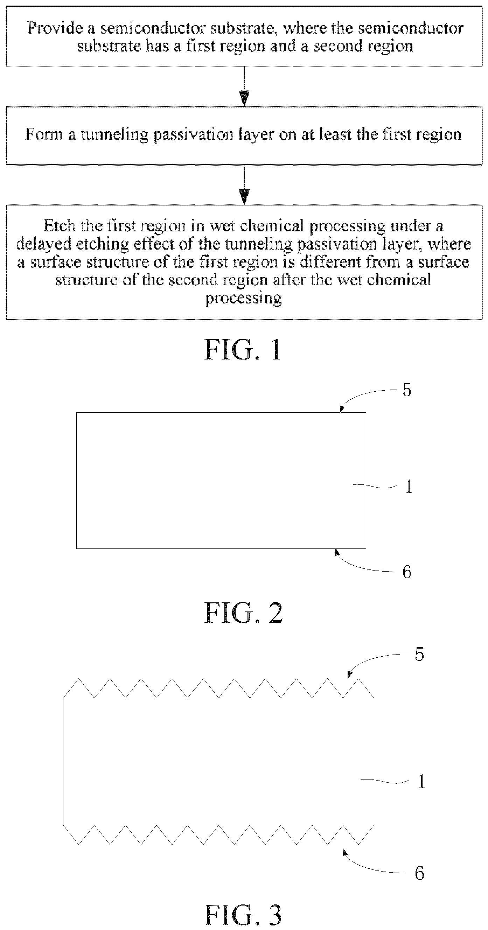

As shown in FIG. 1, an embodiment of the present invention provides a method for manufacturing a solar cell. A solar cell manufactured by the method provided in this embodiment of the present invention may be a double-sided contact solar cell, to be specific, one of a first electrode and a second electrode with opposite polarities is arranged on a front surface of the solar cell, and the other of the first electrode and the second electrode is arranged on a back surface of the solar cell. Alternatively, the solar cell may be a back contact solar cell, to be specific, a first electrode and a second electrode with opposite polarities are both arranged on a back surface of the solar cell.

A manufacturing process is described below according to cross-sectional views shown in FIG. 2 to FIG. 26. Specifically, the method for manufacturing a solar cell includes the following steps.

First, as shown in FIG. 2 and FIG. 3, a semiconductor substrate 1 is provided. As shown in FIG. 2 and FIG. 3, the semiconductor substrate 1 has a first region and a second region.

Specifically, in terms of materials, the semiconductor substrate may be a substrate made of a semiconductor material, for example, a silicon substrate, a germanium silicon substrate, or a germanium substrate. In terms of conductivity types, the semiconductor substrate may be an N-type semiconductor substrate or a P-type semiconductor substrate. In terms of structures, the semiconductor substrate may not been polished, textured, or the like. As shown in FIG. 2, the semiconductor substrate 1 may alternatively be a semiconductor substrate subjected to double-sided polishing. In this case, both a first surface 5 and a second surface 6 opposite to each other in the semiconductor substrate 1 are polished. Alternatively, as shown in FIG. 3, the first surface 5 and the second surface 6 opposite to each other in the semiconductor substrate 1 may be texturized.

In addition, a boundary between the first region and the second region of the semiconductor substrate is a virtual boundary, and specific positions of the first region and the second region on the surfaces of the semiconductor substrate and ranges of the first region and the second region on the corresponding surfaces may be determined according to an actual application scenario, which are not specifically limited herein.

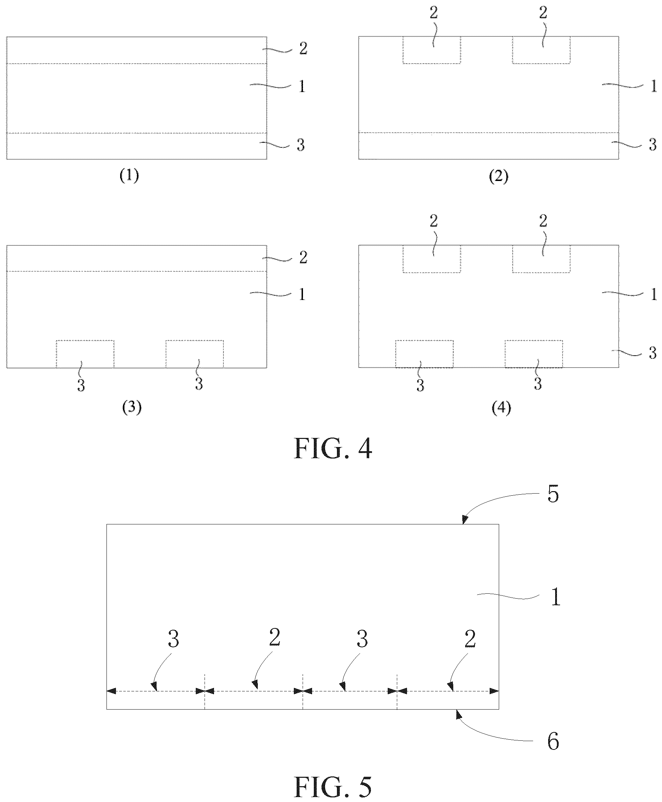

In an example, as shown in parts (1) to (4) in FIG. 4, a first region 2 and a second region 3 may be located on different surfaces of the semiconductor substrate 1. The first region 2 may be located on a front surface of the solar cell. In this case, the second region 3 is located on a back surface of the solar cell. Alternatively, the first region 2 may be located on the back surface. In this case, the second region 3 is located on the front surface. In the foregoing cases, for ranges of the first region 2 and the second region 3 on different surfaces, as shown in the parts (1) and (3) in FIG. 4, a boundary of the first region 2 may coincide with a boundary of the semiconductor substrate 1. Alternatively, as shown in the parts (2) and (4) in FIG. 4, the first region 2 may be a partial region located on a corresponding surface of the semiconductor substrate 1. In addition, as shown in the parts (1) and (2) in FIG. 4, a boundary of the second region 3 may coincide with a boundary of the semiconductor substrate 1. Alternatively, as shown in the parts (3) and (4) in FIG. 4, the second region 3 may be a partial region located on a corresponding surface of the semiconductor substrate 1.

In another example, as shown in FIG. 5, the first region 2 and the second region 3 may alternatively be located on a same surface of the semiconductor substrate 1. In this case, an arrangement of the first region 2 and the second region 3 on the same surface may be determined according to a type of the solar cell and an actual application scenario, which is not specifically limited herein. For example, when the solar cell is the back contact solar cell, first regions 2 and second regions 3 may be alternately arranged on the back surface of the semiconductor substrate 1.

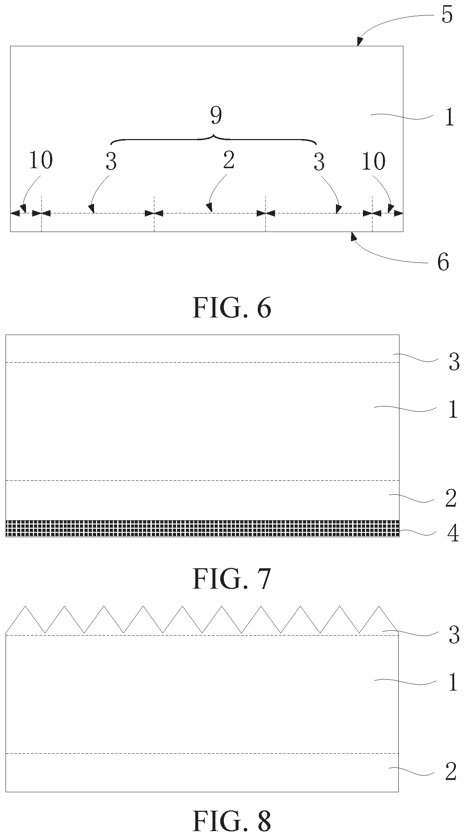

As shown in FIG. 7, FIG. 9, and FIG. 10, a tunneling passivation layer 4 is formed on at least the first region 2.

In an actual application process, the tunneling passivation layer may be formed by a process such as atomic layer deposition or plasma enhanced chemical vapor deposition. A forming range, a thickness, and a material of the tunneling passivation layer may be set according to an actual application scenario, provided that the tunneling passivation layer can be applied to the method for manufacturing a solar cell provided in this embodiment of the present invention.

For example, a thickness of the tunneling passivation layer ranges from 1.4 nm to 1.8 nm. It should be understood that, within a specific range, the thickness of the tunneling passivation layer is proportional to delayed time of the tunneling passivation layer etched. In this case, when the thickness of the tunneling passivation layer ranges from 1.4 nm to 1.8 nm, the thickness of the tunneling passivation layer is moderate. In this way, the delayed time is short because the tunneling passivation layer is easily etched through by subsequently performing the wet chemical processing due to a small thickness of the tunneling passivation layer, thereby further ensuring that a surface of the first region after the wet chemical processing is not excessively processed. In addition, a material waste due to a large thickness of the tunneling passivation layer can also be avoided, thereby reducing manufacturing costs of the solar cell. In addition, the tunneling passivation layer has the delayed etching effect. When the tunneling passivation layer is applied to a tunneling passivation contact structure, the thickness of the tunneling passivation layer is set to the foregoing range, which can also avoid difficulty of carriers passing through the tunneling passivation layer due to the large thickness of the tunneling passivation layer, to reduce resistance of the tunneling passivation layer, thereby further improving photoelectric conversion efficiency of the solar cell.

For example, a material of the tunneling passivation layer is silicon oxide, aluminum oxide, titanium oxide, hafnium oxide, gallium oxide, titanium pentoxide, niobium pentoxide, silicon nitride, silicon carbonitride, aluminum nitride, titanium nitride, or titanium carbonitride. In this case, an optional range of the material of the tunneling passivation layer is large, so that applicability of the method for manufacturing a solar cell provided in this embodiment of the present invention in different application scenarios can be improved.

Certainly, the thickness and the material of the tunneling passivation layer may alternatively be set to other suitable ranges and materials according to actual requirements, which are not specifically limited herein.

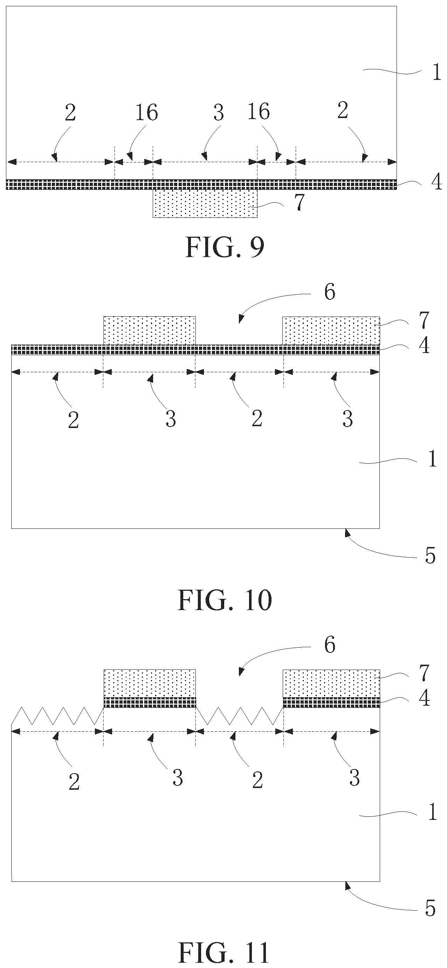

As shown in FIG. 8 and FIG. 11, the first region 2 is etched in wet chemical processing under the delayed etching effect of the tunneling passivation layer 4, where a surface structure of the first region 2 is different from a surface structure of the second region 3 after the wet chemical processing.

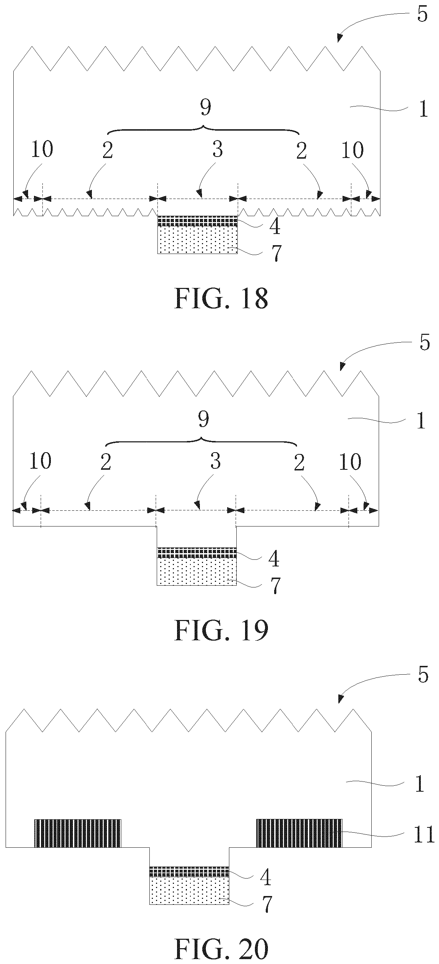

Specifically, the surface structure of the first region is different from the surface structure of the second region after the wet chemical processing, which may include that a type of the surface structure of the first region is different from a type of the surface structure of the second region after the wet chemical processing. For example, after the wet chemical processing, the surface structure of the first region forms a convex structure (where the convex structure is a pyramid base structure that remains after a pyramid structure is polished), and the surface structure of the second region forms a pyramid structure. For another example, after the wet chemical processing, the surface structure of the first region forms a convex structure, and the surface structure of the second region forms an inverted pyramid structure. When the type of the surface structure of the first region is different from the type of the surface structure of the second region after the wet chemical processing, a size of the surface structure of the first region is also different from a size of the surface structure of the second region after the wet chemical processing. It should be understood that, a size of a surface structure is usually limited by a pyramid base width. It should be noted that, as shown in FIG. 18, a pyramid base width of an inverted pyramid structure is a width at an opening of an inverted pyramid.

The surface structure of the first region is different from the surface structure of the second region after the wet chemical processing, which may alternatively include that a size of the surface structure of the first region is different from a size of the surface structure of the second region after the wet chemical processing. For example, after the wet chemical processing, both the surface structure of the first region and the surface structure of the second region form pyramid structures, but a pyramid base width corresponding to the surface structure of the first region is less than a pyramid base width corresponding to the surface structure of the second region.

In an actual application process, processing conditions such as a type, a concentration, and a temperature of a solution for etching the first region in the wet chemical processing, and the surface structure of the first region and the surface structure of the second region after the wet chemical processing may be set according to a type of a to-be-manufactured solar cell and an actual application scenario, which are not specifically limited herein. Before the first region is etched in the wet chemical processing, the tunneling passivation layer is formed on at least the first region. Based on this, in a process of etching the first region in the wet chemical processing, the tunneling passivation layer on at least the first region may have the delayed etching effect, to reduce an etching amount of the surface of the first region by a wet chemical processing solution. It can be seen that, compared with an existing manufacturing method in which the solution for performing the wet chemical processing is directly used to process the surface of the first region, in the manufacturing method provided in this embodiment of the present invention, the surface of the first region after the wet chemical processing is not excessively processed, so that the surface structure of the first region after the wet chemical processing meets requirements of a preset scheme, thereby improving a yield of the solar cell. In addition, the semiconductor substrate after the wet chemical processing is also not excessively thinned, to reduce a risk of cracking after the semiconductor substrate is thinned; and a transmission path of light in the semiconductor substrate can also be increased, to increase a probability that light incident into the semiconductor substrate is absorbed, thereby improving the photoelectric conversion efficiency of the solar cell.

In an actual application process, according to whether the second region is also etched in the wet chemical processing, a process of the wet chemical processing is divided into the following two cases for description.

First case: The second region is etched in the wet chemical processing. The first region and the second region may be simultaneously etched in the wet chemical processing, or the first region and the second region may be separately etched in the wet chemical processing in different operation steps. Details of the surface structure of the first region and the surface structure of the second region after the wet chemical processing may be determined according to a type of a to-be-manufactured solar cell and an actual requirement.

Preferably, when the second region is etched in the wet chemical processing, the first region and the second region are simultaneously etched in the wet chemical processing, to cause the surface structure of the first region to form a convex structure, a pyramid structure, or an inverted pyramid structure, and cause the surface structure of the second region to form a convex structure, a pyramid structure, or an inverted pyramid structure. In this case, the first region and the second region are simultaneously etched in the wet chemical processing, so that efficiency of manufacturing the solar cell can be improved, and productivity of the solar cell can be improved. In addition, after the first region and the second region are simultaneously etched in the wet chemical processing, the surface structure of the first region and the surface structure of the second region have a plurality of possible implementations, so that applicability of the method for manufacturing a solar cell provided in this embodiment of the present invention in different application scenarios can be improved.

In the first case, after the wet chemical processing, if the type of the surface structure of the first region is the same as the type of the surface structure of the second region, the solution for performing the wet chemical processing etches the surfaces of the first region and the second region at different amounts because the tunneling passivation layer is formed on the first region. In this way, a size of the surface structure of the first region is different from a size of the surface structure of the second region after the wet chemical processing.

For example, after the wet chemical processing, when both the surface structure of the first region and the surface structure of the second region are convex structures, a pyramid base width of the first region is less than a pyramid base width of the second region because the tunneling passivation layer is formed on the first region.

For another example, after the wet chemical processing, when both the surface structure of the first region and the surface structure of the second region are pyramid structures, a pyramid base width of the first region is less than a pyramid base width of the second region because the tunneling passivation layer is formed on the first region.

In an actual application process, as shown in FIG. 7, the two opposite surfaces of the semiconductor substrate 1 may both be polished. The first region 2 is entirely arranged on the back surface of the semiconductor substrate 1. The tunneling passivation layer 4 is on only the first region 2. The second region 3 is entirely arranged on the front surface of the semiconductor substrate 1, and a surface of the second region 3 is exposed. In this case, the first region 2 and the second region 3 are simultaneously etched in the wet chemical processing, so that the surface structure of the second region 3 forms the pyramid structure. In the foregoing processing, as shown in FIG. 8, if processing time is short, the surface structure of the first region 2 may be the convex structure. If the processing time is long, the surface of the first region may be etched by the wet chemical processing solution that flows through a hole in the tunneling passivation layer, to form the inverted pyramid structure. When the processing time continues to be prolonged, the tunneling passivation layer is entirely etched by the wet chemical processing solution. In this case, the surface structure of the first region forms the pyramid structure. If the surface structure of the first region after the wet chemical processing forms the pyramid structure, the pyramid base width of the pyramid structure on the surface of the first region is less than the pyramid base width of the pyramid structure on the surface of the second region.

Alternatively, as shown in FIG. 9, the semiconductor substrate 1 has the first surface and the second surface opposite to each other. In addition, a plurality of first regions 2 and a second region 3 are all located on the second surface. In addition, the second surface further has third regions 16. In a direction parallel to the second surface, the first regions 2 and the second region 3 are alternately arranged at intervals. A third region 16 is located between each first region 2 and the adjacent second region 3. The tunneling passivation layer 4 is on at least the first regions 2 and the third regions 16. Based on this, when the solar cell is the back contact solar cell, the second surface corresponds to the back surface of the solar cell. After the tunneling passivation layer 4 is formed and a first doped semiconductor layer 7 is formed on the second region 3 and the tunneling passivation layer 4, the first doped semiconductor layer 7 located on the first regions 2 and the third regions 16 needs to be selectively removed through the wet chemical processing. During the wet chemical processing, the tunneling passivation layer 4 may have a delayed etching effect for the semiconductor substrate located in the first regions 2 and the third regions 16. If processing time is short, surface structures of the first regions 2 and the third regions 16 may be convex structures. If the processing time is long, surfaces of the first regions 2 and the third regions 16 may be etched by the wet chemical processing solution that flows through holes in the tunneling passivation layer 4, to form inverted pyramid structures. When the processing time continues to be prolonged, the tunneling passivation layer 4 is entirely etched by the wet chemical processing solution. In this case, the surface structures of the first regions 2 and the third regions 16 form pyramid structures. If the surface structures of the first regions 2 and the third regions 16 after the wet chemical processing form the convex structures, pyramid base widths of the first regions 2 and the third regions 16 are less than a pyramid base width of the second region 3.

Second case: The second region is not etched in the wet chemical processing. In this case, the surface structure of the first region after the wet chemical processing may be determined according to a type of the solar cell and an actual requirement.

In a possible implementation, as shown in FIG. 10, the step of forming a tunneling passivation layer 4 on at least the first region 2 includes: forming the tunneling passivation layer 4 on at least the first region 2 and the second region 3; and after the forming the tunneling passivation layer 4 on at least the first region 2 and the second region 3, and before the etching the first region 2 in wet chemical processing, the method for manufacturing a solar cell further includes: forming a first doped semiconductor layer 7 on at least the tunneling passivation layer 4 corresponding to the second region 3. In addition, the surface structure of the second region 3 is a convex structure, a pyramid structure, or an inverted pyramid structure; and the surface structure of the first region 2 after the wet chemical processing is a convex structure, a pyramid structure, or an inverted pyramid structure.

When the foregoing technical scheme is used, the first doped semiconductor layer and the tunneling passivation layer located on the second region may form a tunneling passivation contact structure. In this case, the solar cell manufactured by the manufacturing method provided in this embodiment of the present invention is a tunneling oxide passivation contact solar cell. The tunneling passivation layer in the tunneling passivation contact structure allows majority carriers to tunnel into the first doped semiconductor layer and also inhibits minority carriers passing through the first doped semiconductor layer, so that the majority carriers are transported through the first doped semiconductor layer and collected by corresponding electrodes, a recombination rate of carriers of different conductivity types on a surface of the second region is reduced, and interface passivation and selective carrier collection are implemented, thereby further improving the photoelectric conversion efficiency of the solar cell. In addition, the surface structure of the second region and the surface structure of the first region after the wet chemical processing have a plurality of possible implementations, and an appropriate implementation may be selected according to requirements of different application scenarios, so that applicability of the method for manufacturing a solar cell provided in this embodiment of the present invention in different application scenarios can be improved.

Specifically, in this case, the first region and the second region may be located on a same surface of the semiconductor substrate, or may be located on different surfaces of the semiconductor substrate.

In an example, the semiconductor substrate may have a first surface and a second surface opposite to each other; in a direction parallel to the second surface, the second surface has first regions and a second region that are alternately arranged; a surface structure of the second region is a convex structure; and a surface structure of one of the first region after the wet chemical processing is a pyramid structure or an inverted pyramid structure. When the foregoing technical scheme is used, the pyramid structure or the inverted pyramid structure is a textured structure, and the textured structure has a light trapping effect. Therefore, when the second surface having the first region corresponds to the front surface of the solar cell, more light can be refracted into the semiconductor substrate through the surface of the first region, thereby further improving the photoelectric conversion efficiency of the solar cell. In addition, the surface structure of the second region is the convex structure. Because the convex structure is a pyramid base structure that remains after the pyramid structure is polished, a top surface of the pyramid base structure is flat, and the surface of the second region is a flat polished surface. In this way, quality of the tunneling passivation layer and the first doped semiconductor layer on the second region can be improved, so that a tunneling passivation contact structure formed by the tunneling passivation layer and the first doped semiconductor layer located on the second region can have excellent interface passivation and selective carrier collection characteristics.

In another example, when the first region and the second region are located on different surfaces of the semiconductor substrate, if the first region is arranged on a surface of the semiconductor substrate opposite to the front surface, the surface structure of the first region after the wet chemical processing may be a pyramid structure or an inverted pyramid structure, so that more light can be refracted into the semiconductor substrate through the surface of the first region. In this case, the surface structure of the second region may be a convex structure or an inverted pyramid structure. When the surface structure of the second region is the convex structure, more light can be reflected back into the semiconductor substrate through the surface of the second region, and can be reused by the semiconductor substrate. In addition, a total surface area of inverted pyramid textured surfaces is larger than a total surface area of polished surfaces within a specific range of the second region. Therefore, when the surface structure of the second region is the inverted pyramid structure, a contact area between the first doped semiconductor layer formed on the second region and the second region may be increased, so that interface resistance of the second region can be reduced.

In still another example, when the first region and the second region are located on different surfaces of the semiconductor substrate, if the first region is arranged on a surface of the semiconductor substrate opposite to the back surface, after the wet chemical processing, the surface structure of the first region may be a convex structure or an inverted pyramid structure, and the surface structure of the second region may be a convex structure, a pyramid structure, or an inverted pyramid structure. For beneficial effects in this case, reference may be made to the foregoing beneficial effects. Details are not described herein again.

For the foregoing first doped semiconductor layer, a conductivity type and a doping concentration of the first doped semiconductor layer may be set according to an actual application scenario, provided that the first doped semiconductor layer can be applied to the method for manufacturing a solar cell in this embodiment of the present invention. For example, the first doped semiconductor layer may be an N-type semiconductor layer doped with N-type conductive particles such as phosphorus. For another example, the first doped semiconductor layer is a P-type semiconductor layer. The conductivity type of the first doped semiconductor layer may be the same as or opposite to a conductivity type of the semiconductor substrate.

In addition, in terms of an internal arrangement form of substances, the first doped semiconductor layer may be amorphous, microcrystalline, monocrystalline, polycrystalline, nanocrystalline, or the like. In terms of materials, the first doped semiconductor layer may be made of a semiconductor material such as silicon, silicon germanium, germanium, doped silicon carbide, or gallium arsenide. In terms of passivation, the first doped semiconductor layer may be a hydrogenated doped layer. A thickness of the first doped semiconductor layer may be set according to an actual requirement, which is not specifically limited herein. For example, the thickness of the first doped semiconductor layer may range from 20 nm to 600 nm.

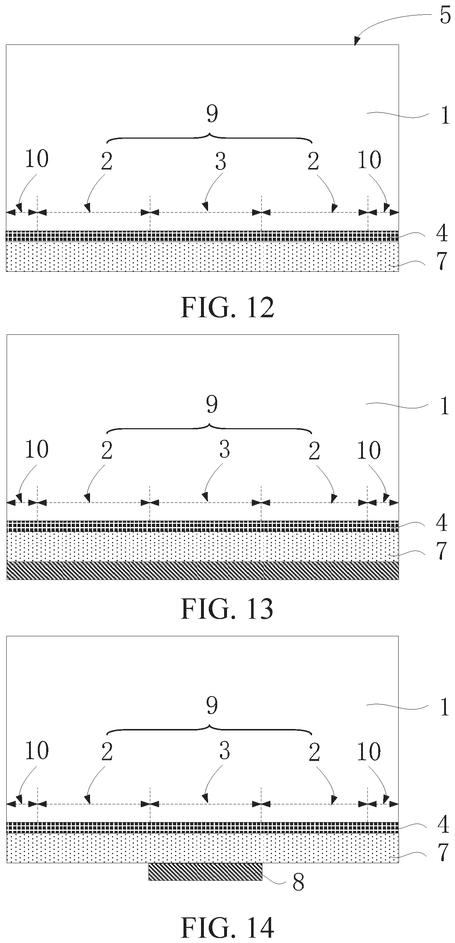

For a forming range of the first doped semiconductor layer, as shown in FIG. 10, the first doped semiconductor layer 7 may be formed on only the tunneling passivation layer 4 corresponding to the second region 3; or as shown in FIG. 12, the first doped semiconductor layer 7 may be entirely on the tunneling passivation layer 4.

In a possible implementation, the semiconductor substrate has the first surface and the second surface opposite to each other; and in a direction parallel to the second surface, the second surface has first regions and a second region that are alternately arranged. In this case, the forming a tunneling passivation layer on at least the first region includes: forming the tunneling passivation layer on at least the first regions and the second region. In addition, the surface structure of one of the first regions after the wet chemical processing is a convex structure, a pyramid structure, or an inverted pyramid structure; and the surface structure of the second region after the wet chemical processing is a convex structure.

Specifically, in terms of passivation, the corresponding solar cell in this case may be a tunneling oxide passivation contact solar cell. Based on this, after the forming the tunneling passivation layer on at least the first regions and the second region, and before the etching the first region in wet chemical processing, the method for manufacturing a solar cell further includes: forming a first doped semiconductor layer on at least the tunneling passivation layer corresponding to the second region. The first doped semiconductor layer and the tunneling passivation layer located on the second region form a tunneling passivation contact structure included in the tunneling oxide passivation contact solar cell. In this case, for the surface structure of the first region and the surface structure of the second region after the wet chemical processing, reference may be made to the foregoing descriptions. Details are not described herein again.

In addition, in terms of positions of electrodes, the solar cell corresponding to this case may be a double-sided contact solar cell or a back contact solar cell. During actual application, the semiconductor substrate included in the double-sided contact solar cell has a first electrode region and a second electrode region respectively corresponding to two electrodes of opposite conductivity types. Based on this, when the solar cell corresponding to this case is the double-sided contact solar cell, the first electrode region may be entirely or partially arranged on the first surface of the semiconductor substrate; and the second electrode region is arranged at the second region of the second surface.

In addition, in this case, if the first surface of the solar cell is also etched in the wet chemical processing, the first surface and the first region may be simultaneously etched in the wet chemical processing, or the first surface and the first region may be separately etched in the wet chemical processing in different operation steps.

Preferably, the first surface and the first region are simultaneously etched in the wet chemical processing, to cause a surface structure of the first surface to be different from the surface structure of the first region. In this case, when the foregoing technical scheme is used, the first surface and the first region are simultaneously etched in the wet chemical processing, so that efficiency of manufacturing the solar cell can be improved, and productivity of the solar cell can be improved.

In an actual application process, according to different positions of the electrodes included in the solar cell on the semiconductor substrate, a result of simultaneously etching the first surface and the first region in the wet chemical processing may be divided into the following two cases for description:
In an example, as shown in FIG. 11, when the solar cell is the double-sided contact solar cell, the first surface 5 and the first region 2 are simultaneously etched in the wet chemical processing, to cause the surface structure of the first surface 5 to form a convex structure, and cause the surface structure of the first region 2 to form the convex structure, the pyramid structure, or the inverted pyramid structure.

In an actual application process, when the surface structure of the first surface after the wet chemical processing is the convex structure, the first surface is a flat polished surface. The polished surface has a good reflection characteristic, and the surface structure of the first surface after the wet chemical processing forms the convex structure. Therefore, when the first surface corresponds to the back surface of the double-sided contact solar cell, light reaching the first surface can be at least partially reflected back into the semiconductor substrate and can be reused by the semiconductor substrate, thereby further improving the photoelectric conversion efficiency of the double-sided contact solar cell. In this case, the second surface corresponds to the front surface of the double-sided contact solar cell. Specifically, the surface structure of the first region after the wet chemical processing may be set according to an actual requirement. When the surface structure of the first region after the wet chemical processing is the convex structure, a surface of the first region is flat, so that densification of a passivated anti-reflection layer formed on the first region can be improved, In this way, a passivation effect of the passivated anti-reflection layer on the surface of the first region is improved, thereby further improving the photoelectric conversion efficiency of the double-sided contact solar cell. When the surface structure of the first region after the wet chemical processing is the pyramid structure or the inverted pyramid structure, more light may be refracted into the semiconductor substrate through the surface of the first region, thereby further improving the photoelectric conversion efficiency of the double-sided contact solar cell. It can be seen that, the surface structure of the first region after the wet chemical processing may be determined according to requirements of different application scenarios.

For example, as shown in FIG. 11, a pyramid base width of the first surface 5 is greater than a pyramid base width of the first region 2. In this case, a pyramid base width corresponding to a convex structure is greater than pyramid base widths corresponding to a pyramid structure and an inverted pyramid structure. Therefore, when the surface structure on the first surface 5 is the convex structure and the pyramid base width of the first surface 5 is greater than the pyramid base width of the first region 2, the surface structure of the first region 2 after the wet chemical processing forms the pyramid structure or the inverted pyramid structure. In this case, the second surface 6 corresponds to the front surface of the double-sided contact solar cell, so that more light can be refracted into the semiconductor substrate 1 through the pyramid structure or the inverted pyramid structure on the first region 2.

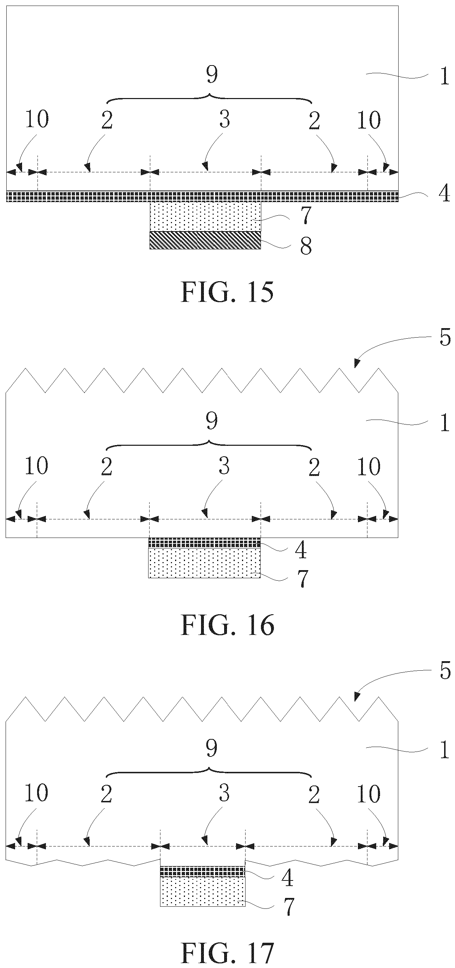

In another example, as shown in FIG. 16 to FIG. 19, when the solar cell is the back contact solar cell, the first surface 5 and the first region 2 are simultaneously etched in the wet chemical processing, to cause the surface structure of the first surface 5 to form a pyramid structure, and cause the surface structure of the first region 2 to form the convex structure, the pyramid structure, or the inverted pyramid structure.

In an actual application process, in this case, after the providing a semiconductor substrate, and before the etching the first region in wet chemical processing, the method for manufacturing a solar cell may include: as shown in FIG. 12, sequentially forming the tunneling passivation layer 4 and the first doped semiconductor layer 7 that are entirely arranged on the second surface 6; and as shown in FIG. 15, patterning the first doped semiconductor layer 7, so that only the first doped semiconductor layer 7 located on the second region 3 is retained.

Specifically, as shown in FIG. 12, the tunneling passivation layer 4 and the first doped semiconductor layer 7 may be sequentially and entirely formed on the second surface by a process such as atomic layer deposition or plasma enhanced chemical vapor deposition. Next, as shown in FIG. 13 and FIG. 14, a mask layer 8 is formed above the first doped semiconductor layer 7 located on the second region 3. The mask layer 8 may be a film having a specific etching selection ratio to the first doped semiconductor layer 7, for example, a photoresist layer, a silicon nitride layer, or a silicon oxide layer. A forming process of the mask layer 8 may be determined according to a material of the mask layer 8, which is not specifically limited herein. Finally, as shown in FIG. 15, under a masking effect of the mask layer 8, the first doped semiconductor layer 7 may be patterned by a process such as a laser etching process, a plasma etching process, or wet chemical processing. When the first doped semiconductor layer 7 may be patterned by the wet chemical processing process, the first region 2 may be directly processed by the same processing solution after the foregoing patterning.

When the foregoing technical scheme is adopted, when the solar cell is a back contact solar cell, because the first doped semiconductor layer is located on the second surface of the semiconductor substrate, the second surface of the semiconductor substrate corresponds to the back surface of the back contact solar cell, and the first surface of the semiconductor substrate corresponds to the front surface of the back contact solar cell. In this case, after the wet chemical processing, more light can be refracted into the semiconductor substrate through the first surface, thereby further improving the photoelectric conversion efficiency of the back contact solar cell. In addition, after the wet chemical processing, the surface structure of the first region located on the second surface may form one of the convex structure, the pyramid structure, or the inverted pyramid structure, so that applicability of the manufacturing method provided in this embodiment of the present invention in different application scenarios is improved. Specifically, the surface structure of the first region after the wet chemical processing may be determined according to requirements of different application scenarios.

For example, as shown in FIG. 16, a pyramid base width of the first surface 5 is less than a pyramid base width of the first region 2. In this case, as described above, the pyramid base widths corresponding to the pyramid structure and the inverted pyramid structure are both less than the pyramid base width corresponding to the convex structure. Therefore, when the surface structure on the first surface 5 is the pyramid structure and the pyramid base width of the first surface 5 is less than the pyramid base width of the first region 2, the surface structure of the first region 2 after the wet chemical processing is the convex structure. In this case, the second surface 6 corresponds to the back surface of the back contact solar cell, so that at least part of light can be reflected back into the semiconductor substrate 1 through the surface of the first region 2, thereby further improving the photoelectric conversion efficiency of the back contact solar cell.

In an example, as shown in FIG. 16 to FIG. 19, when the solar cell is the back contact solar cell, a pyramid base width of the second region 3 is different from the pyramid base width of the first region 2 after the wet chemical processing. In this case, a type of the surface structure arranged on the second region 3 may be the same as or different from a type of the surface structure arranged on the first region 2 after the wet chemical processing.

For example, when the surface structure of the second region is the convex structure and the surface structure of the first region is also the convex structure after the wet chemical processing, a pyramid base width of the convex structure arranged on the surface of the first region is different from a pyramid base width of the convex structure arranged on the second region after the wet chemical processing.

For another example, when the surface structure of the second region is the convex structure and the surface of the first region structure is the inverted pyramid structure after the wet chemical processing, a pyramid base width of the convex structure arranged on the surface of the second region is greater than a pyramid base width of the inverted pyramid structure on the first region after the wet chemical processing.

When the foregoing technical scheme is used, specific positions of the first doped semiconductor layer and a second doped semiconductor layer (or a doped region) may be distinguished based on a difference between the pyramid base width of the second region and the pyramid base width of the first region after the wet chemical processing, so that the first doped semiconductor layer and the second doped semiconductor layer (or the doped region) are more distinguishable. In this way, difficulty of accurately arranging electrodes with a same polarity on the first doped semiconductor layer and the second doped semiconductor layer (or the doped region) respectively can be reduced, so that a risk of causing a short circuit in the back contact solar cell is reduced because the first doped semiconductor layer and the second doped semiconductor layer (or the doped region) of opposite conductivity types are coupled through the electrodes, thereby improving electrical stability of the back contact solar cell.

In an example, as shown in FIG. 19 to FIG. 21, in the second case, when the solar cell is the back contact solar cell, the surface of the first region 2 is recessed into the semiconductor substrate 1 relative to the surface of the second region 3 after the wet chemical processing. In this case, the first doped semiconductor layer 7 and a second doped semiconductor layer 12 (or a doped region 11) that have opposite doping types in the back contact solar cell are respectively formed on the second region 3 and on (or in) the first region 2. Therefore, when the surface of the first region 2 is recessed into the semiconductor substrate 1 relative to the surface of the second region 3 after the wet chemical processing, the first doped semiconductor layer 7 may be staggered with at least a part of the second doped semiconductor layer 12 (or the first doped semiconductor layer 7 may be entirely staggered with the doped region 11) in a thickness direction of the semiconductor substrate 1, so that no electric leakage can occur between the first doped semiconductor layer 7 and the second doped semiconductor layer 12 (or the doped region 11).

Specifically, a depth by which the surface of the first region is recessed into the semiconductor substrate relative to the surface of the second region after the wet chemical processing may be set according to an actual requirement, provided that the depth can be applied to the method for manufacturing a solar cell provided in this embodiment of the present invention. For example, the surface of the first region is recessed by 0.5 µm to 8 µm into the semiconductor substrate relative to the surface of the second region after the wet chemical processing.

In an example, as shown in FIG. 19 to FIG. 21, in the second case, when the solar cell is the back contact solar cell, the second surface 6 has a middle region 9 and edge isolation regions 10 extending outward from the middle region 9; the first regions 2 and the second region 3 are located in the middle region 9; and a surface of one of the edge isolation regions 10 is recessed into the semiconductor substrate relative to the surface of the second region 3 after the wet chemical processing. In this case, in a process of actually manufacturing the first doped semiconductor layer 7 and the second doped semiconductor layer 12 (or the doped region 11) that have opposite doping types included in the back contact solar cell, a doped element of one of the first doped semiconductor layer 7 and the second doped semiconductor layer 12 (or the doped region 11) is also doped into a side surface of the semiconductor substrate 1. Based on this, the surface of the edge isolation region 10 is recessed into the semiconductor substrate relative to the surface of the second region 3 after the wet chemical processing, so that the other of the first doped semiconductor layer 7 and the second doped semiconductor layer 12 (or the doped region 11) can be separated from the side surface of the semiconductor substrate 1 by the edge isolation region 10. In this way, no electric leakage occurs between the side surface of the semiconductor substrate 1 and the other of the first doped semiconductor layer 7 and the second doped semiconductor layer 12 (or the doped region 11), thereby improving the photoelectric conversion efficiency of the back contact solar cell.

Specifically, a depth by which the surface of the edge isolation region is recessed into the semiconductor substrate relative to the surface of the second region after the wet chemical processing may be set according to an actual requirement, provided that the depth can be applied to the method for manufacturing a solar cell provided in this embodiment of the present invention. For example, the surface of the edge isolation region is recessed by 0.5 µm to 8 µm into the semiconductor substrate relative to the surface of the second region after the wet chemical processing.

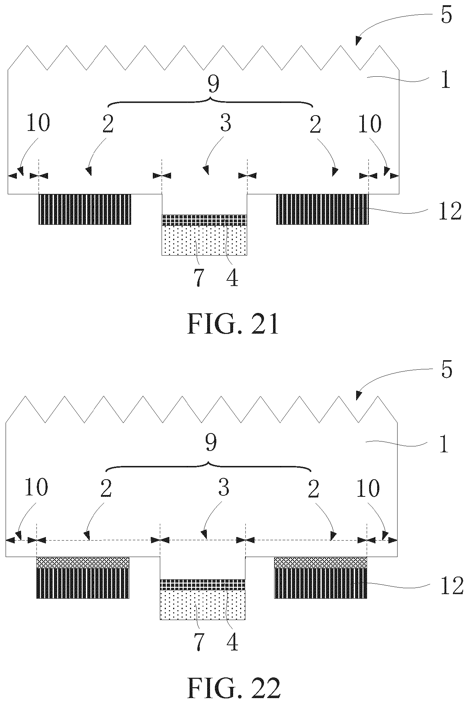

In an example, in the second case, when the solar cell is the back contact solar cell, after the etching the first region in wet chemical processing, the method for manufacturing a solar cell further includes: as shown in FIG. 20, forming a doped region 11 in the first region 2, where a conductivity type of the doped region 11 is opposite to a conductivity type of the first doped semiconductor layer 7; or as shown in FIG. 21, forming a second doped semiconductor layer 12 on the first region 2, where a conductivity type of the second doped semiconductor layer 12 is opposite to a conductivity type of the first doped semiconductor layer 7.

In an actual application process, when the doped region needs to be formed in the first region, the doped region may be formed by a process such as plasma injection or diffusion under a masking effect of a corresponding mask layer. When the second doped semiconductor layer needs to be formed on the first region, an intrinsic semiconductor layer may be formed on the first doped semiconductor layer and the first region by a process such as chemical vapor deposition. Then, the intrinsic semiconductor layer may be doped by a process such as plasma injection or diffusion, to obtain a second doped semiconductor material layer. Finally, the second doped semiconductor material layer located on the first doped semiconductor layer is selectively removed, to obtain the second doped semiconductor layer.

When the second doped semiconductor layer of the solar cell is obtained, before the second doped semiconductor layer is formed, a tunneling layer may be formed on the first region and the first doped semiconductor layer by a process such as atomic layer deposition. As shown in FIG. 22, after the second doped semiconductor layer 12 is formed, the tunneling layer may be patterned under at least a masking effect of the second doped semiconductor layer 12, so that at least the tunneling layer located between the semiconductor substrate 1 and the second doped semiconductor layer 12 is retained.

After the doped region or the second doped semiconductor layer is formed, if the back contact solar cell does not include other film layers, a first electrode in ohmic contact with the doped region (or the second doped semiconductor layer) and a second electrode in ohmic contact with the first doped semiconductor layer may be separately formed by a process such as screen printing, to obtain the back contact solar cell.

In another case, after the doped region or the second doped semiconductor layer is formed, a surface passivation layer may alternatively be formed on the second surface of the semiconductor substrate, to passivate a side of the first doped semiconductor layer and the doped region (or the second doped semiconductor layer) facing away from the semiconductor substrate, to reduce a carrier recombination rate on the side of the first doped semiconductor layer and the doped region facing away from the semiconductor substrate, thereby further improving the photoelectric conversion efficiency of the back contact solar cell.

Specifically, when the solar cell includes the doped region, after the forming a doped region in the first region, the method for manufacturing a solar cell further includes: forming a surface passivation layer on at least the first doped semiconductor layer and the doped region; or
when the solar cell includes the second doped semiconductor layer, after the forming a second doped semiconductor layer on the first region, the method for manufacturing a solar cell further includes: forming a surface passivation layer on at least the first doped semiconductor layer and the second doped semiconductor layer.

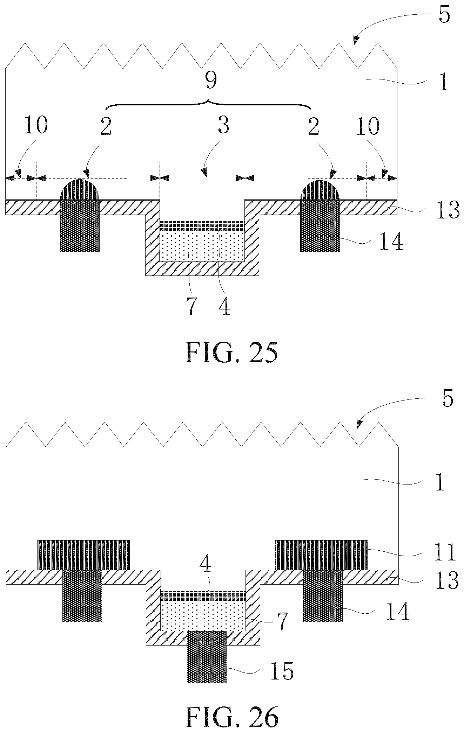

In an actual application process, the surface passivation layer may be formed by a process such as chemical vapor deposition. A thickness and a material of the surface passivation layer may be set according to an actual requirement, which is not specifically limited herein. For example, the material of the surface passivation layer may be one or more of silicon nitride, silicon oxide, silicon oxynitride, aluminum oxide, silicon carbide, or amorphous silicon. In addition, as shown in FIG. 26, after a surface passivation layer 13 is formed, a first electrode 14 in ohmic contact with the doped region 11 (or the second doped semiconductor layer 12) and a second electrode 15 in ohmic contact with the first doped semiconductor layer 7 may be separately formed by a process such as screen printing, to obtain the back contact solar cell.

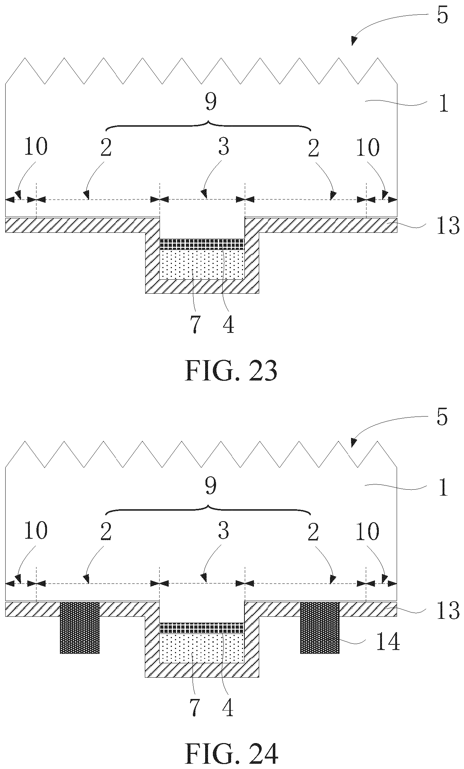

In an example, when the solar cell includes the doped region, after the etching the first region in wet chemical processing, and before the forming a doped region in the first region, the method for manufacturing a solar cell further includes: as shown in FIG. 23, forming a surface passivation layer 13 on at least the first region 2 and the first doped semiconductor layer 7; and as shown in FIG. 24, forming a first electrode 14 penetrating the surface passivation layer 13, where a bottom of the first electrode 14 is in contact with the first region 2. As shown in FIG. 25, the forming a doped region 11 in the first region 2 includes: forming the doped region 11 in the first region 2 by the first electrode 14 as a doping source.

In an actual application process, the surface passivation layer may be formed on the first region and the first doped semiconductor layer by the foregoing process. For a material and a thickness of the surface passivation layer, reference may be made to the foregoing descriptions. Then, an electrode window may be provided at a contact position between the surface passivation layer and the first region by a process such as laser etching or plasma etching. Then, the first electrode penetrating the surface passivation layer through the electrode window may be formed by a process such as screen printing. A material of the first electrode may be determined according to a doping type of the doped region. For example, when the doped region is an N-type doped region, the material of the first electrode may be antimony. For another example, when the doped region is a P-type doped region, the material of the first electrode may be aluminum, gallium, or indium. Finally, the first electrode may be thermally treated in a manner such as sintering, to form the doped region in the first region by the first electrode as the doping source.

It should be noted that, in this case, the second electrode may be formed simultaneously with the first electrode or formed in a step different from a step of the first electrode. The second electrode is in ohmic contact with the first doped semiconductor layer.

When the foregoing technical scheme is used, the surface passivation layer may passivate the surface of the first region and a side of the first doped semiconductor layer facing away from the semiconductor substrate, to reduce a carrier recombination rate on the surface of the first region and the side of the first doped semiconductor layer facing away from the semiconductor substrate. In addition, the first electrode penetrating the surface passivation layer is used as the doping source, so that the doped region can be formed only within a range in which the first region is in contact with the first electrode, so that no electric leakage occurs when the doped region comes into contact with the first doped semiconductor layer. In addition, a process of forming a mask layer by forming the doped region only in the first region can be saved, thereby simplifying a process of manufacturing the back contact solar cell.

In the foregoing descriptions, technical details such as patterning and etching of the layers are not described in detail. However, a person skilled in the art should understand that a layer, a region, and the like in a required shape may be formed through various technical means. In addition, to form the same structure, a person skilled in the art may further design a method that is not exactly the same as the method described above. In addition, although the embodiments are separately described above, this does not mean that the measures in the embodiments cannot be advantageously used in combination.

The embodiments of the present disclosure are described above. However, the embodiments are merely for illustrative purposes and are not intended to limit the scope of the present disclosure. The scope of the present disclosure is defined by the appended claims and equivalents thereof. A person skilled in the art may make various substitutes and modifications without departing from the scope of the present disclosure, and the substitutes and modifications shall fall within the scope of the present disclosure.

The foregoing described apparatus embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the schemes of the embodiments. A person of ordinary skill in the art may understand and implement the method without any creative effort.

"One embodiment", "Embodiment", or "one or more embodiments" mentioned in this specification mean that particular features, structures, or characteristics described with reference to the embodiments may be included in at least one embodiment of this application. In addition, the word example of "in an embodiment" herein does not necessarily all refer to a same embodiment.

In this specification provided herein, numerous specific details are described. However, it can be understood that, the embodiments of this application may be practiced without these specific details. In some instances, well-known methods, structures, and technologies are not shown in detail, so that understanding of this specification is not obscured.

Finally, it should be noted that, the foregoing embodiments are merely used for describing the technical schemes of this application, but are not intended to limit this application. Although this application is described in detail with reference to the foregoing embodiments, it should be understood that a person of ordinary skill in the art may still make modifications to the technical schemes described in the foregoing embodiments or make equivalent replacements to some technical features thereof, without departing from the spirit and scope of the technical schemes of the embodiments of this application.

## Claims

1. A method for manufacturing a solar cell, comprising:
providing a semiconductor substrate 1, wherein the semiconductor substrate 1 has a first region 2 and a second region 3;
forming a tunneling passivation layer 4 on at least the first region 2; and
etching the first region 2 in wet chemical processing under a delayed etching effect of the tunneling passivation layer 4, wherein a surface structure of the first region 2 is different from a surface structure of the second region 3 after the wet chemical processing.

2. The method for manufacturing a solar cell according to claim 1, wherein a thickness of the tunneling passivation layer 4 ranges from 1.4 nm to 1.8 nm; and/or
a material of the tunneling passivation layer 4 is silicon oxide, aluminum oxide, titanium oxide, hafnium oxide, gallium oxide, titanium pentoxide, niobium pentoxide, silicon nitride, silicon carbonitride, aluminum nitride, titanium nitride, or titanium carbonitride.

3. The method for manufacturing a solar cell according to claim 1, wherein the first region 2 and the second region 3 are simultaneously etched in the wet chemical processing, to cause the surface structure of the first region 2 to form a convex structure, a pyramid structure, or an inverted pyramid structure, and cause the surface structure of the second region 3 to form a convex structure, a pyramid structure, or an inverted pyramid structure.

4. The method for manufacturing a solar cell according to claim 1, wherein the forming a tunneling passivation layer 4 on at least the first region 2 comprises: forming the tunneling passivation layer 4 on at least the first region 2 and the second region 3;
after the forming the tunneling passivation layer 4 on at least the first region 2 and the second region 3, and before the etching the first region 2 in wet chemical processing, the method for manufacturing a solar cell further comprises: forming a first doped semiconductor layer 7 on at least the tunneling passivation layer 4 corresponding to the second region 3;
the surface structure of the second region 3 is a convex structure; and the surface structure of the first region 2 after the wet chemical processing is a convex structure, a pyramid structure, or an inverted pyramid structure.

5. The method for manufacturing a solar cell according to claim 1, wherein the semiconductor substrate 1 has a first surface 5 and a second surface 6 opposite to the first surface; in a direction parallel to the second surface 6, the second surface 6 has first regions 2 and a second region 3 that are alternately arranged;
the forming a tunneling passivation layer 4 on at least the first region 2 comprises: forming the tunneling passivation layer 4 on at least the first regions 2 and the second region 3;
the surface structure of one of the first regions 2 after the wet chemical processing is a convex structure, a pyramid structure, or an inverted pyramid structure; and the surface structure of the second region 3 after the wet chemical processing is a convex structure.

6. The method for manufacturing a solar cell according to claim 5, wherein after the forming the tunneling passivation layer 4 on at least the first regions 2 and the second region 3, and before the etching the first region 2 in wet chemical processing, the method for manufacturing a solar cell further comprises: forming a first doped semiconductor layer 7 on at least the tunneling passivation layer 4 corresponding to the second region 3.

7. The method for manufacturing a solar cell according to claim 6, wherein the surface structure of the first region 2 after the wet chemical processing is the pyramid structure or the inverted pyramid structure.

8. The method for manufacturing a solar cell according to any one of claims 5 to 7, wherein the first surface 5 and the first region 2 are simultaneously etched in the wet chemical processing, to cause a surface structure of the first surface 5 to be different from the surface structure of the first region 2.

9. The method for manufacturing a solar cell according to claim 8, wherein the solar cell is a double-sided contact solar cell; and
the first surface 5 and the first region 2 are simultaneously etched in the wet chemical processing, to cause the surface structure of the first surface 5 to form a convex structure, and cause the surface structure of the first region 2 to form the convex structure, the pyramid structure, or the inverted pyramid structure.

10. The method for manufacturing a solar cell according to claim 9, wherein a pyramid base width of the surface structure formed on the first surface 5 is greater than a pyramid base width of the surface structure formed on the first region 2.

11. The method for manufacturing a solar cell according to claim 8, wherein the solar cell is a back contact solar cell; and
the first surface 5 and the first region 2 are simultaneously etched in the wet chemical processing, to cause the surface structure of the first surface 5 to form a pyramid structure, and cause the surface structure of the first region 2 to form the convex structure, the pyramid structure, or the inverted pyramid structure.

12. The method for manufacturing a solar cell according to claim 11, wherein a pyramid base width of the surface structure arranged on the first surface 5 is less than a pyramid base width of the surface structure formed on the first region 2.

13. The method for manufacturing a solar cell according to claim 5, wherein the solar cell is a back contact solar cell; and
a pyramid base width of the surface structure formed on the second region 3 is different from a pyramid base width of the surface structure formed on the first region 2 after the wet chemical processing.

14. The method for manufacturing a solar cell according to claim 11, wherein after the providing a semiconductor substrate 1, and before the etching the first region 2 in wet chemical processing, the method for manufacturing a solar cell comprises:
sequentially forming the tunneling passivation layer 4 and the first doped semiconductor layer 7 that are entirely arranged on the second surface 6; and
patterning the first doped semiconductor layer 7, so that only the first doped semiconductor layer 7 located on the second region 3 is retained.

15. The method for manufacturing a solar cell according to claim 11, wherein a surface of the first region 2 is recessed into the semiconductor substrate 1 relative to a surface of the second region 3 after the wet chemical processing.

16. The method for manufacturing a solar cell according to any one of claims 11 to 15, wherein the second surface 6 has a middle region 9 and edge isolation regions 10 extending outward from the middle region 9; the first regions 2 and the second region 3 are located in the middle region 9; and
a surface of one of the edge isolation regions 10 is recessed into the semiconductor substrate 1 relative to the surface of the second region 3 after the wet chemical processing.

17. The method for manufacturing a solar cell according to any one of claims 11 to 15, wherein after the etching the first region 2 in wet chemical processing, the method for manufacturing a solar cell further comprises:
forming a doped region 11 in the first region 2, wherein a conductivity type of the doped region 11 is opposite to a conductivity type of the first doped semiconductor layer 7; or
forming a second doped semiconductor layer 12 on the first region 2, wherein a conductivity type of the second doped semiconductor layer 12 is opposite to a conductivity type of the first doped semiconductor layer 7.

18. The method for manufacturing a solar cell according to claim 17, wherein after the forming a doped region 11 in the first region 2, the method for manufacturing a solar cell further comprises: forming a surface passivation layer 13 on at least the first doped semiconductor layer 7 and the doped region 11; or
after the forming a second doped semiconductor layer 12 on the first region 2, the method for manufacturing a solar cell further comprises: forming a surface passivation layer 13 on at least the first doped semiconductor layer 7 and the second doped semiconductor layer 12.

19. The method for manufacturing a solar cell according to claim 17, wherein after the etching the first region 2 in wet chemical processing, and before the forming a doped region 11 in the first region 2, the method for manufacturing a solar cell further comprises:
forming a surface passivation layer 13 on at least the first region 2 and the first doped semiconductor layer 7; and
forming a first electrode 14 penetrating the surface passivation layer 13, wherein a bottom of the first electrode 14 is in contact with the first region 2; and
the forming a doped region 11 in the first region 2 comprises: forming the doped region 11 in the first region 2 by the first electrode 14 as a doping source.

20. A solar cell, prepared by the method for manufacturing a solar cell according to any one of claims 1 to 19.
